# EUROPEAN PATENT SPECIFICATION

(11) **EP 3 301 709 B1**
(45) Date of publication and mention of the grant of the patent: **12.02.2020**
(21) Application number: 17190358.6
(22) Date of filing: 11.09.2017
(51) Int. Cl.: H01L 23/34, G01K 3/10

(54) **DEVICE AND METHOD FOR COOLING A SEMICONDUCTOR ARRANGEMENT**
VORRICHTUNG UND VERFAHREN ZUM KÜHLEN EINER HALBLEITERANORDNUNG
DISPOSITIF ET PROCÉDÉ DE REFROIDISSEMENT D'UN AGENCEMENT SEMI-CONDUCTEUR

(30) Priority: 28.09.2016 DE 102016118293
(43) Date of publication of application: 04.04.2018
(73) Proprietor: GE Energy Power Conversion Technology Ltd, Rugby Warwickshire CV21 1BU (GB)
(72) Inventor: BRUECKNER, Thomas, 12277 Berlin (DE); KELLER, Christian Bernhard, 12277 Berlin (DE); JANNING, Joerg, 12277 Berlin (DE); KOCUR, Michael, 12277 Berlin (DE)
(74) Representative: Rüger Abel Patentanwälte PartGmbB

(56) References cited:
- WO-A1-2005/043618
- CN-A- 104 863 881
- US-A1- 2014 345 846

## Description

The present invention relates to a device and a method for cooling a semiconductor arrangement. The semiconductor arrangement comprises at least one power semiconductor with one semiconductor chip that is arranged on a carrier. The semiconductor chip is usually cast or inaccessibly arranged in a housing. The semiconductor arrangement can, for example, belong to an inverter circuit.

Frequent temperature fluctuations put strain on the power semiconductors. These are composed of different materials with different size coefficients of thermal expansion. In particular, with the temperature changes with an amount above a threshold value, mechanical stresses arise in the power semiconductor, which adversely affect its service life. With frequent temperature fluctuations, cracks can occur in the power semiconductor, in particular in the solder joints. Such crack formation can also cause the thermal conductivity from the semiconductor chip to the environment or to a heat sink to be reduced. The temperature directly at or in the semiconductor chip can thereby increase, which in turn leads to an increased mechanical load due to temperature fluctuations and ultimately reduces the service life of the power semiconductor.

Silicon carbide semiconductor chips are nowadays increasingly used, since they have high dielectric strength, and with the same size - compared with silicon semiconductor chips - enable higher switching capacities and low switching losses. These silicon carbide power semiconductors are particularly sensitive to temperature fluctuations.

U.S. Patent Application 14/692836 describes a system for regulating the temperature changes of semiconductor components of a converter. Thereby, reactive power is generated, in order to counteract a dropping temperature. In various IGBT bridges of the converter, different sizes of reactive powers can be generated. Thereby, the rotational speed of a cooling fan can be reduced or the fan can be stopped completely to enable an increase in the coolant temperature and thus not to counteract the reactive power generation for the temperature increase.

U.S. 9,194,376 B2 describes a system and a method for estimating the remaining service life of a device. Thereby, based on a temperature-dependent load on the device, the remaining service life is estimated.

U.S. 9,190,923 B2 describes a converter arrangement in which the switching frequency of the converter is controlled depending on the ambient conditions. Thus, the load on the power semiconductors can be reduced, depending on the ambient conditions; however, the quality of the output values current and voltage are also affected.

A similar method is also described in U.S. 8,046,616 B2. There, the operating condition of a semiconductor module is changed, for example, between a state with full power and an idle state. Switching or increasing the power of the semiconductor module should alleviate temperature fluctuations and thus reduce the load on the semiconductor.

DE 10 2014 112 458 A1 discloses a method of controlling a cooling device for increasing the service life of a semiconductor arrangement. The object of this method is to control the temperature of the semiconductor arrangement to an expected temperature value. The expected temperature value in the semiconductor arrangement of a converter of a photovoltaic system can be determined, for example, by a weather forecast. The cooling device is then controlled such that the semiconductor arrangement keeps the temperature that corresponds to the expected value as constant as possible. If it should turn out that the cooling capacity is insufficient to maintain the expected value, a temperature above the expected value is set as the target temperature. The result is that the cooling device will once again be in a position to actually regulate the now increased target temperature and that a sufficient power reserve is available for this purpose.

A disadvantage of this method is that, although the temperature fluctuations of the semiconductor are reduced by the regulation, the semiconductor is, however, operated at a much higher average temperature than if it were continuously cooled with the maximum cooling capacity. Since semiconductors often have the property of causing higher losses at higher temperatures, the efficiency of the semiconductor arrangement deteriorates noticeably with this method.

US 2014/0345864 describes a method of cooling a heat generating device, in which the cooling rate is determined at least in part based on the rate of change of temperature of the heat generating device.

WO 2005/043618 describes a method of cooling an inverter.

CN 104 863 881 describes a method of controlling a fan speed for cooling electronic equipment.

On this basis, it can regarded as a task of the present invention to create a device for cooling a semiconductor arrangement which reduces the amplitude of the temperature changes, while at the same time, in the long term, by using the full cooling capacity, keeping the component temperature at the lowest possible value, and achieves this at low cost and with minimal effort. Moreover, the cooling device should not, or not significantly, interfere with the electrical operation of the circuit to which the semiconductor arrangement belongs, such as an inverter circuit of a regenerative energy supply system, such as a photovoltaic system or a wind power plant.

This task is solved with a device having the characteristics of patent claim 1 and with a method having the characteristics of patent claim 15.

The device and the method are used for the cooling of a semiconductor arrangement with at least one power semiconductor, which comprises a semiconductor chip arranged on a carrier. The semiconductor arrangement can be, for example, part of an inverter, which converts an input voltage into an output voltage. For example, the inverter can convert a DC input voltage of a regenerative energy source, for example, collector modules of a photovoltaic system, into an AC output voltage for an AC voltage grid. In other regenerative energy sources, the semiconductor arrangement can generally be part of a converter, wherein either a DC input voltage or an AC input voltage can be present at the input.

A cooling device exists for cooling the semiconductor arrangement. The cooling device is controlled by a control device. For this, the control device transmits a control variable to the cooling device. For example, the cooling device can comprise one or a plurality of fans, wherein the control variable sets the rotational speed of the at least one fan. The cooling device cools the semiconductor arrangement so that a coolant flows, for example, along the outside and/or in cooling channels of the semiconductor arrangement. The coolant can be, for example, water or air, wherein an air flow is preferably created by fans.

The device comprises a change-determining means, which is configured to determine a temperature change value. The temperature change value indicates a temperature change of a component temperature of the semiconductor arrangement depending on time. The change-determining means can determine an updated temperature change value continuously, quasi-continuously or at certain time intervals. The temperature change value can be determined by a time derivation of the component temperature or by establishing the difference between two temporally spaced component temperature values.

The temperature change value is transmitted to the control device or determined in the control device. A change default value is also given to the control device. The change default value specifies a desired or permissible temperature change, in particular a temperature decrease of the component temperature. The change default value is constant or parameter-dependent, for example, in the form of a characteristic curve or a characteristic map. According to the invention, the change default value in a semiconductor arrangement of a photovoltaic system inverter is set dependent on the time of day and/or the geographical location of the photovoltaic system. The control device determines a change difference between the temperature change value and the change default value. The control variable is determined depending on the change difference, with the aim of reducing the amount of the change difference.

The change default value sets a target temperature change, in particular a target temperature decrease, for the component temperature. The change default value serves as the reference variable. The control device thereby generates a control variable to regulate the temperature change of the component temperature according to the reference variable and thus according to the change default value. The target temperature change could also be a zero change or a target temperature increase.

The change default value can be adapted, for example, to a cyclical common temperature decrease. For example, in a photovoltaic system, the sunlight is weaker in the evening hours and the component temperature decreases according to the waning sunlight.

With changing ambient conditions, temperature changes in the component temperature, in terms of amount, can occur in high gradients. For example, if a photovoltaic system is shadowed by clouds, a temperature decrease of the component temperature occurs at a large temperature gradient. This temperature gradient is limited by the invention in that the cooling capacity is reduced via the control variable in order to adapt the temperature change value to the change default value and to make the change difference as close to zero as possible. It is possible to reduce the cooling capacity to zero. For example, the fans of the cooling device can be brought to a standstill. Since no heat should be supplied via a heating device, it is possible that the temperature change value, in terms of amount, is still greater than the change default value; however, the temperature decrease is limited by the ambient conditions and not enlarged by additional cooling.

This in turn has the result that a limited time change in the ambient conditions, which causes a temperature reduction of the component temperature, comprises a limited gradient and thus the amount of the temperature change is reduced. Temperature changes below a certain amount of temperature change have only a limited impact on the service life of the semiconductor arrangement, because the mechanical loads within the materials of the power semiconductor are not as great. Using the invention, it is therefore possible to reduce the temperature change or amount of temperature change of the component temperature in the event of temperature fluctuations, arising, for example, due to changing ambient conditions, and thereby increasing the overall service life of the semiconductor arrangement.

Thereby, the invention performs no temperature regulation of the component temperature. A temperature regulation can cause higher average operating temperatures because the available cooling capacity is limited and a control reserve must be provided so that the target temperature value, depending on the current ambient and operating conditions, must be set correspondingly high if necessary. Higher temperatures can entail even greater losses and thus reduce the efficiency of the semiconductor arrangement. In contrast, according to the invention using simple means, the overall service life of the semiconductor arrangement is increased without influencing the electrical operating condition of the semiconductor arrangement - for example, by increasing or lowering an electrical power, e.g. by generating reactive power in an inverter circuit as described in U.S. Patent Application 14/692836, or by changing the switching frequency as suggested in U.S. 9,190,923 B2. Thus, the efficiency of the arrangement is also not adversely influenced to a significant extent.

The solution according to the invention accepts that the preset target temperature change - for example, a moderate target temperature decrease - is not always possible. For example, no temperature decrease can be achieved during strong sunlight in a photovoltaic system. In such cases, the maximum available cooling capacity of the cooling device is requested by the control device, even if, as a result, the preset target temperature change cannot be reached. The object of the invention is to prevent or limit strong temperature drops due to changing ambient conditions, such as shadowing of a photovoltaic system caused by clouds, to increase the service life of the semiconductor arrangement.

The power semiconductors of the semiconductor arrangement are preferably silicon carbide semiconductors. Silicon carbide power semiconductor chips have high dielectric strength and compared with silicon semiconductor chips of the same size and enable higher switching capacities, while their switching losses are low.

A preferred exemplary embodiment contains a component temperature sensor, which directly measures the temperature of the component at a surface of the semiconductor arrangement. The component temperature sensor is preferably attached to the carrier of the semiconductor arrangement or to a heat sink of the semiconductor arrangement that is connected to the carrier. The component temperature sensor can be located, for example, between the carrier and the heat sink or inside the heat sink. In addition, it is also possible that the sensor can be integrated into the power semiconductor and, for example, arranged in a modular design on the inside of the carrier of a semiconductor on a baseplate or on a substrate. Such sensors are often implemented in semiconductor devices. The component temperature sensor does not measure the chip temperature of the semiconductor chip directly, but the component temperature of the semiconductor arrangement and the temperature inside the semiconductor chip are connected. Temperature measurement using the component temperature sensor is simple and inexpensive. A determination of the temperature inside the semiconductor chip would, however, require a much more complicated calculation and is neither required nor provided here. By means of the detected component temperature, the temperature change value can be determined easily by the change-determining means. The determination of the temperature change value is not time-critical and, depending on the type of cooling system and coolant, can typically be updated in time intervals in the range of greater than 100 milliseconds to a few seconds (for example, up to 10 seconds). The temperature change value can thus be determined based on the difference between two successively measured component temperature values divided by the specified time interval between the measurements. A precise gradient calculation of the component temperature prevents high-frequency interferences of the temperature signal of the component temperature sensor leading to adverse effects for controlling.

It is also possible to provide a coolant temperature sensor. The coolant temperature sensor measures the relevant temperature for the cooling of the coolant used, such as, for example, the temperature of the coolant before the coolant is guided past the semiconductor arrangement, for example, in the case of air cooling, the air temperature of the intake air from the surroundings of the semiconductor arrangement. In the case of water cooling, the cooling water inlet temperature is measured before cooling.

In addition, in one exemplary embodiment, a current sensor for measuring a current value of the semiconductor arrangement and/or a voltage sensor for measuring a voltage value of the semiconductor arrangement can be present. Since current and voltage sensors are typically used to control the primary function of the semiconductor arrangement, and since they exist anyway to protect them, this results in no additional expenditure. Based on the current value and/or the voltage value, the operating condition of the semiconductor arrangement and the heat loss and power loss generated by the semiconductor arrangement can be deduced.

In one embodiment of the invention, the ambient temperature and the current value and/or the voltage value can be transmitted to the change-determining means. Based on the ambient temperature and, for example, the power loss or waste heat determined based on the current value or the voltage value, a temperature value for the temperature of the power semiconductor and/or a temperature change value can be determined. For this purpose, the change-determining means preferably comprise a parameter-dependent characteristic of the semiconductor arrangement. The parameter-dependent characteristic can preferably be in the form of a characteristic curve or a characteristic map, a lookup table, a model or the like, so that no calculation is necessary. The parameter-dependent characteristic indicates the relationship between the parameters and/or measured values and the component temperature and/or the temperature change value. The following input variables can be transmitted to or specified for the parameter-dependent characteristic:
- at least one value that describes the electrical power of the semiconductor arrangement, for example, the current value and/or the voltage value, and/or
- the coolant temperature for cooling of the semiconductor arrangement, and/or
- a parameter describing the cooling capacity of the cooling device, for example, the control variable or the actual rotational speed of the at least one fan.

The parameter-dependent characteristic, dependent on the input variables, specifies the component temperature or the temperature change value. Using such a parameter-dependent characteristic, a temperature change value can be determined without direct measurement of the component temperature based on the operating state of the semiconductor arrangement and the coolant temperature. If a system comprises a plurality of semiconductor arrangements, the number of required temperature sensors can thus be reduced, as the coolant temperature must only be measured once and the respective temperature change value associated with a semiconductor arrangement can be determined taking into account the respective operating state of the semiconductor arrangement.

It is advantageous when the change-determining means are part of the control device.

The control device may comprise a regulator, such as a PI regulator or a PID regulator. The change difference is transmitted to the regulator as an input variable. The regulator at its output provides a regulator output variable, which can be used as a control variable. The regulator calculates the regulator output variable with the aim of reducing the change difference and regulating ideally to zero.

It is preferable that the regulator output variable be limited. For this purpose, the regulator output variable may be supplied to a limiter, which limits this to a maximum value, and outputs the limited regulator output variable as a control variable. This is in recognition of the fact that the cooling device has a maximum cooling capacity, for example, that a fan has a maximum rotational speed.

In a preferred embodiment, the semiconductor arrangement is part of a converter circuit or an inverter circuit. The converter circuit or inverter circuit in turn can be part of an energy production plant based on regenerative energy, such as a photovoltaic system or a wind power plant.

Advantageous configurations of the method are evident from the dependent claims, the description and the drawings. Hereinafter, preferred exemplary embodiments of the invention will be explained with reference to the accompanying drawings. The drawings in detail are as follows:
Figure 1 is a highly schematic representation, similar to a block diagram, of a system for conversion of regenerative energy into an AC voltage for an AC voltage grid with an exemplary embodiment of a cooling device for cooling a semiconductor arrangement of an inverter circuit,
Figure 2 shows the semiconductor arrangement and the cooling device of Figure 1 in a schematic representation similar to a block diagram,
Figure 3 is a schematic diagram of an embodiment of the system with the cooling device of Figure 1,
Figure 4 is a schematic diagram for an alternative embodiment for the realization of the cooling device for the system according to Figures 1 to 3,
Figure 5 is an exemplary representation of the number N of the temperature fluctuations associated with the respective temperature difference between a temperature variation for a conventional inverter circuit of a photovoltaic system over one year,
Figure 6 shows the percentage of the service life consumption L of the system over one year, based on the temperature fluctuations of Figure 5,
Figure 7 shows the percentage of the service life consumption L of an inverter circuit of a photovoltaic system with the use of the invention,
Figure 8 shows exemplary time curves for a standardized output power of an inverter circuit of a photovoltaic system and the sunlight with respect to a standard value of the sunlight (STC), specified in percent in each case during the daylight hours of a day,
Figure 9 shows an exemplary curve for an air temperature in the environment and the chip temperature of a semiconductor chip resulting from the course of the output power of the inverter circuit of Figure 8 and the air temperature and component temperature in a conventional system, and
Figure 10 shows an exemplary curve of the air temperature in the environment and the chip temperature of the semiconductor chip in the invention that results based on the output power of the inverter circuit according to Figure 8 and the air temperature and component temperature when using the invention.

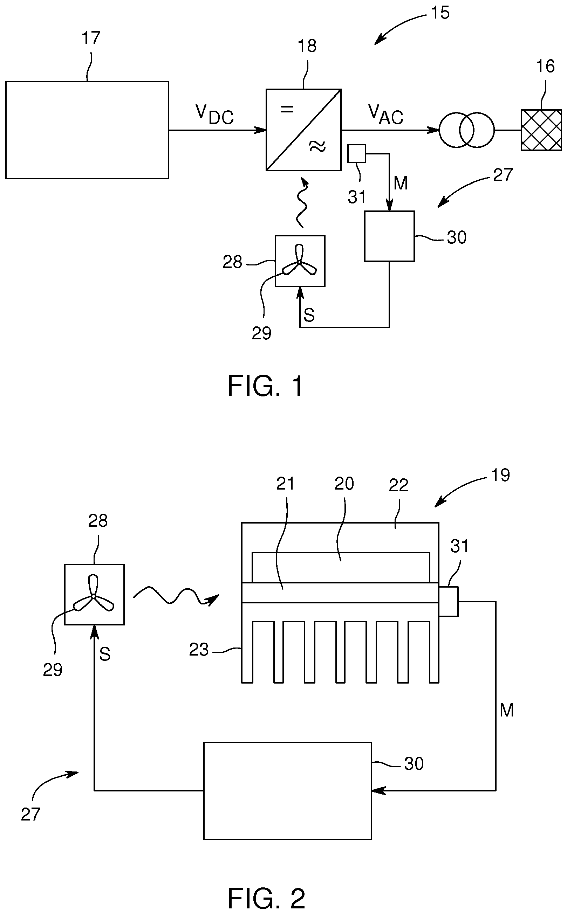

Figure 1 illustrates, in highly schematic form, a system 15 for generating an AC output voltage V_{AC}, for example, for an AC voltage grid 16 that is connected via a transformer. The system 15 comprises a regenerative energy source 17 which, according to the example, provides a DC input voltage V_{DC} depending on the ambient conditions. In the exemplary embodiment, an arrangement with one or more collector modules is used as a regenerative energy source 17, such that the system 15 represents a photovoltaic system. The regenerative energy source 17 can also be formed by a generator of a wind power plant or comprise such. Instead of the DC input voltage V_{DC}, an AC input voltage can be provided by the regenerative energy source 17. Such regenerative energy sources 17 in operation are dependent on the ambient conditions, in particular the weather conditions.

The system 15 comprises a converter circuit and, in the exemplary embodiment, an inverter circuit 18. The direct voltage supplied by the regenerative energy source 17 represents a DC input voltage V_{DC} for the inverter circuit 18, providing an AC output voltage V_{AC} for the AC voltage grid 16 at its output.

The inverter circuit 18 comprises one or a plurality of semiconductor arrangements 19 with at least one power semiconductor (Figure 2). The power semiconductor can, for example, have a modular design. The power semiconductor thereby comprises a semiconductor chip 20, which is arranged on a carrier 21. A plurality of semiconductor chips 20 can be arranged together on the carrier 21. The at least one semiconductor chip 20 on the carrier 21 is covered by means of an encapsulation 22 and is thus enclosed by the carrier 21 from one side and the encapsulation 22 from the other side. The encapsulation 22 can be, for example, a glob top. Alternatively, the power semiconductor can be constructed with another design, for example, a pressure contact housing.

To cool the semiconductor chips 20, the carrier 21 can be connected to a heat sink 23 to improve the thermal conduction of the at least one semiconductor chip 20 via the carrier to the exterior environment.

A device 27 is associated with the inverter circuit 18 or the at least one semiconductor arrangement 19 of the inverter circuit 18 for cooling the at least one semiconductor arrangement 19. The device 27 comprises a controllable cooling device 28 which, in the exemplary embodiment, comprises one or a plurality of fans 29. Air according to the example is used as a coolant which, by means of the at least one fan 29, flows outside along the semiconductor arrangement 19 or the heat sink 23.

The device 27 also comprises a control device 30, to which at least one measured value M of a measuring device 31 is transmitted. The measuring device 31 is associated with the inverter circuit 18. On the output side, the control device 30 provides a control variable S to control the cooling device 28. In the described exemplary embodiment, the control variable S specifies the rotational speed of the at least one fan 29.

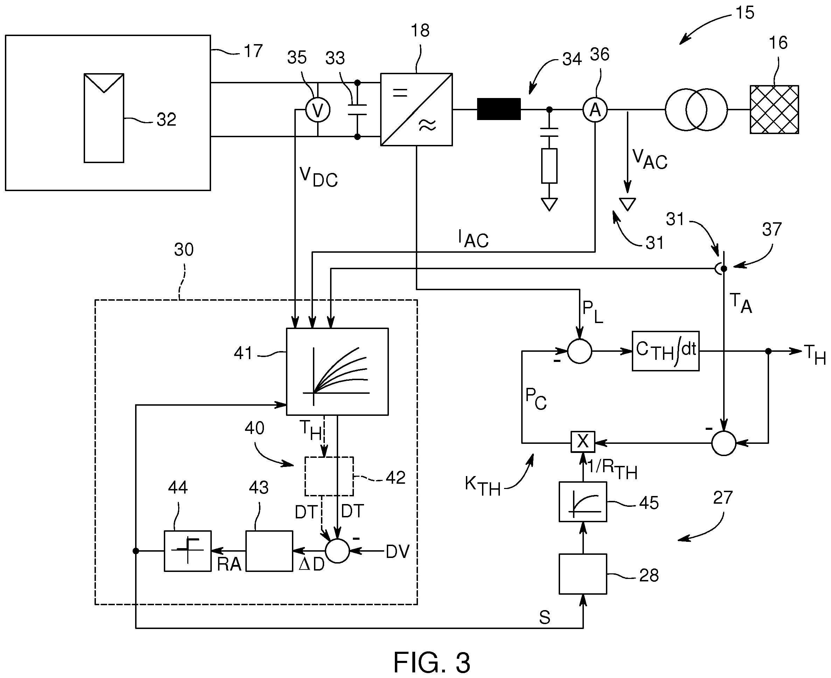

An exemplary embodiment of the system 15, in the form of a photovoltaic system with one or a plurality of collector modules 32, is illustrated in Figure 3. There, an input capacitor 33 is connected at the input of the inverter circuit 18 for smoothing or buffering the DC input voltage V_{DC}. A filter 34, comprising a coil, a filter capacitor and a filter resistor, is connected at the output of the inverter circuit 18.

The measuring device 31 according to the example comprises a voltage sensor 35 for measuring the DC input voltage V_{DC}, a current sensor 36 for measuring the AC output current I_{AC} and a coolant temperature sensor 37. The coolant temperature sensor 37 measures the temperature of the coolant used before the coolant is directed past the semiconductor arrangement. According to the example, air as the coolant is sucked in from the surroundings, so that the coolant temperature sensor 37 measures the air temperature T_{A} in the area of the inverter circuit 18 or the at least one semiconductor arrangement 19. In this exemplary embodiment, the air temperature T_{A}, the DC input voltage V_{DC} and the AC output current I_{AC} represent the measured values M of the measuring device 31.

The measured values are transmitted to the control device 30.

The device 27 also comprises change-determining means 40, which are configured to determine a temperature change value DT, which describes a time-dependent temperature change of a component temperature T_{H} of the at least one semiconductor arrangement 19 of the inverter circuit 18. In the exemplary embodiment illustrated in Figure 3, the change-determining means 40 are part of the control device 30 and comprise a parameter-dependent characteristic 41 of the semiconductor arrangement 19 or the inverter circuit 18. The parameter-dependent characteristic 41 describes the relationship between the temperature change value DT and/or the component temperature T_{H} and one or a plurality of parameters. The parameter-dependent characteristic 41 can be specified in the form of a lookup table, characteristic map, characteristic curve, function or the like. In the exemplary embodiment described here, one or a plurality of parameters are taken into account in the parameter-dependent characteristic 41, which describes the current electrical operating condition of the inverter circuit 18, for example, at least one electrical value measured in the inverter circuit 18, based on which the power loss P_{L} of the inverter circuit 18 and thus the generated heat can be characterized. The DC input voltage V_{DC} determined by the sensors 35, 36 and the AC output current I_{AC} are, according to the example, measured and transmitted to the control device 30. An additional input variable for the parameter-dependent characteristic 41 is the air temperature T_{A}.

At the time of each inspection, the parameter-dependent characteristic 41 depending on at least one parameter (here: control variable S) and/or at least one measured value M (here: DC input voltage V_{DC}, AC output current I_{AC} and air temperature T_{A}) provides the temperature change value DT. Instead of the control variable S, especially for a regulated cooling device 28, another parameter describing the current cooling capacity, for example, the actual rotational speed of a fan, can also be transmitted. From the at least one parameter or the at least one measured value, the parameter-dependent characteristic 41 can determine and output the temperature change value DT without a component temperature T_{H} needing to be calculated and differentiated (Figure 3). This is highly advantageous and is also practical to the extent that the difference between the current cooling capacity and the currently determined heat loss is directly proportional to the temperature change value DT.

Alternatively, a differential stage 42 can exist (shown by the dotted lines in Figure 3), if the parameter-dependent characteristic 41, instead of outputting the temperature change value DT, outputs a value for the semiconductor temperature T_{H}. By establishing the difference between two temporally spaced values for the component temperature values T_{H} and dividing this difference by the length of the time interval, the temperature change value DT can be obtained in the differential stage 42. The duration of the time interval can be selected to be relatively large, for example in the area of 100 milliseconds up to a few seconds, for example, 1 to 10 seconds, so as to exclude very short-term fluctuations.

From the temperature change value DT and a change default value DV, the control device 30 determines a change difference ΔD based on the establishment of a corresponding difference. The change default value DV represents a reference variable. It specifies a target temperature change, in particular a decrease in the component temperature T_{H}. The change default value DV is therefore less than zero. It can, for example, be in the range of -5 K/h to -25 K/h. The change difference ΔD thus corresponds to the control deviation between the current temperature change value DT and the change default value DV. The change default value DV could, in principle, be at least temporarily equal to or greater than zero.

The change difference ΔD is transmitted on the input side to a regulator 43. The regulator 43 is designed as a PI regulator according to the example. Through its integral part, it determines a regulator output variable RA at the output of the regulator 43 with the aim of reducing the regulator difference and thus the change difference ΔD to zero.

According to the example, the regulator output variable RA is supplied to a limiter 44, which limits the regulator output variable RA in its amount and transmits it as control variable S to the cooling device 28. By limiting, the limitations of the cooling device 28 are taken into account, which, in the described exemplary embodiment, can only produce a maximum possible cooling capacity and a maximum rotational speed of the fan 29.

Depending on the control variable S, the cooling device 28 produces the flow of coolant along the inverter circuit 18 and, according to the example, a flow of air. The thermal properties Kₜₕ that determine the component temperature T_{H} are also shown in Figure 3 as a block diagram. The rotational speed of the fan or another characterizing value of the condition of the cooling device 28 determines, depending on a characteristic curve 45, which describes the thermal conduction of the inverter circuit 18 or the at least one semiconductor arrangement 19, the thermal resistance R_{TH} or the thermal conductivity, which is formed by the multiplicative inverse of the thermal conductivity resistance. The thermal conductivity and the temperature difference between the component temperature T_{H} and the air temperature T_{A} correspond to a cooling capacity P_{C} the of cooling device 28. The difference from the cooling capacity P_{C} and the power loss P_{L} of the inverter circuit 18 gives the component temperature T_{H}, taking into account the thermal capacity C_{TH}. These thermal properties Kₜₕ describe the influence of the control variable S on the component temperature T_{H}. The component temperature T_{H} is determined in the exemplary embodiment according to Figure 3 as described above and used for control or regulation.

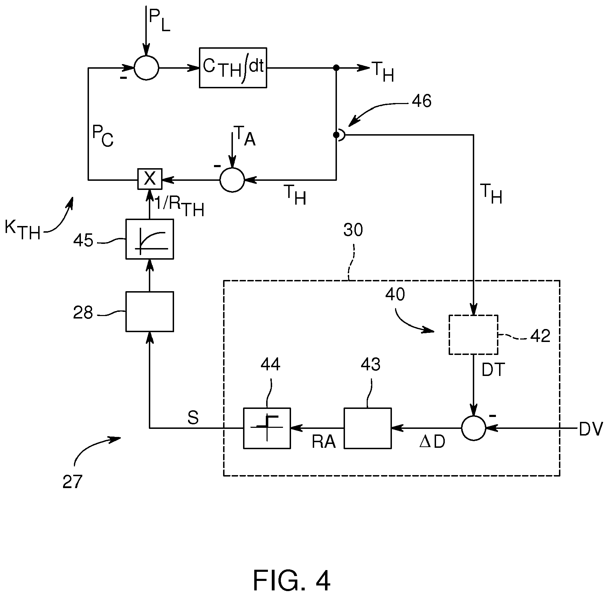

A modified exemplary embodiment is illustrated in Figure 4. Instead of the coolant temperature sensor 37, there is a component temperature sensor 46, which directly measures the temperature of the carrier 21 or the temperature of the heat sink 23 as the component temperature T_{H}. The measured component temperature T_{H} can be transmitted immediately to the change-determining means 40 or the differential stage 42 in the control device 30. The parameter-dependent characteristic 41 from Figure 3 can be omitted. Accordingly, sensors which record the current operating condition of the inverter circuit 18 are also not required. At least, their measuring signals do not need to be supplied to the control device 30 or the device 27. In addition, a coolant temperature sensor 37 for measuring the ambient temperature T_{A} can be made available as an option.

The thermal characteristics Kₜₕ described in the context of Figure 3, which specify how the control variable S, via the cooling device 28, affects the component temperature T_{H}, correspond to those in Figure 4, so that the above explanation can be referenced. The exemplary embodiment according to Figure 4 has the advantage that it is easily possible to determine the temperature change value DT.

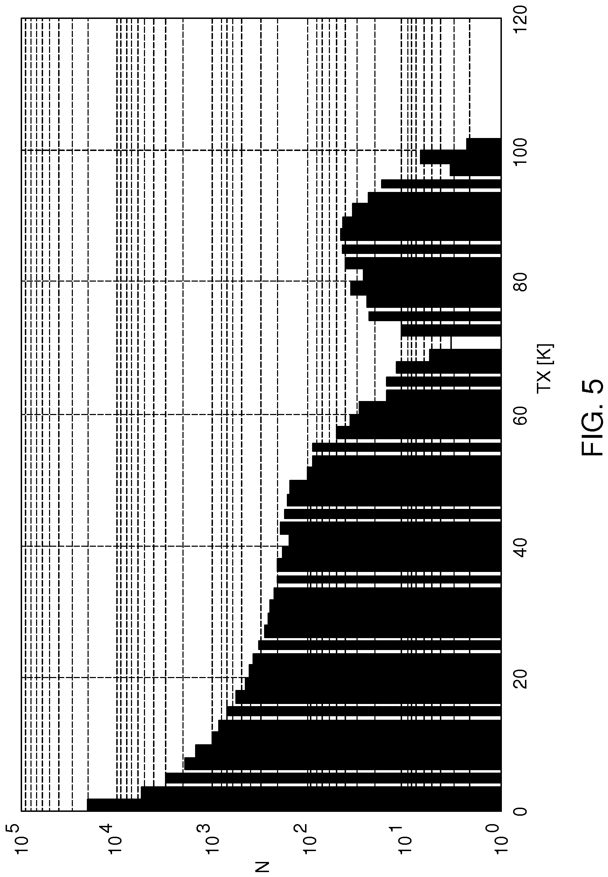

The functioning of the device 27 according to the invention is described based on Figures 5-10.

In Figure 5, the frequency of fluctuations in the semiconductor chip temperature in the inverter circuit of a photovoltaic system associated with the respective temperature difference TX, i.e. the difference between a maximum temperature value and a minimum temperature value of a temperature fluctuation, is applied. Figure 5 gives an exemplary indication of the number of temperature fluctuations for a photovoltaic system over one year. Two ranges of temperature fluctuations can be seen in Figure 5. In this example, temperature fluctuations in the range of approximately 70K and larger are largely attributable to daily cycles, i.e. between day and night. These fluctuations cannot be influenced by the system according to the invention. In this example, temperature fluctuations in the range below approximately 70K are due to weather changes within one day, e.g. due to a change in cloud cover. These cycles are of shorter duration than the daily cycles, e.g. in the range of one or a few minutes up to one or a few hours. Changes in the component temperature which are caused by these cycles can be reduced in amplitude by the system according to the invention as explained based on the following figures.

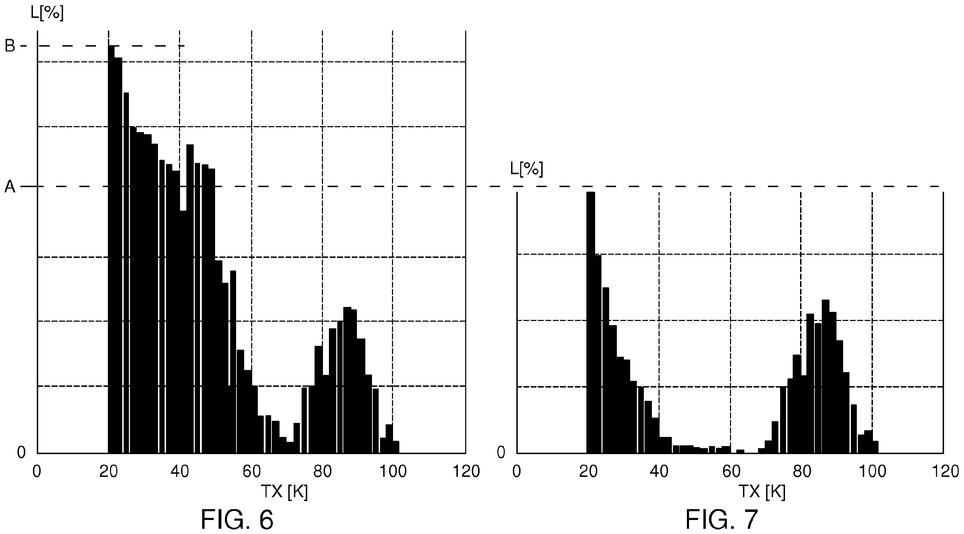

A distribution of changes of the semiconductor chip temperature according to Figure 5 gives a percentage of the service life consumption L of a semiconductor device depending on a temperature fluctuation with a certain temperature difference TX, as shown in Figure 6. Compared with Figure 5, it can be seen that the temperature fluctuations with a temperature difference below approximately 70K, which are caused by weather influences, account for a very high proportion of the service life consumption L of the inverter circuit 18. Temperature fluctuations below 20K change were not taken into account in this representation, since fluctuations with very low changes have almost no effect on the aging of the semiconductor devices. The limit value for this may, depending on the technology used, also be above or below 20K. The representation according to Figure 6 relates to a system 15, without a device 27 for cooling according to the invention. By way of example, a first percentage value A and a second percentage value B, which is greater than the first percentage value A, are recorded. The total of all percentage values for the temperature changes of 20 K to approx. 70 K indicate the percentage of the service life consumption L of the semiconductor devices of the inverter circuit 18 over one year which is caused by weather influences.

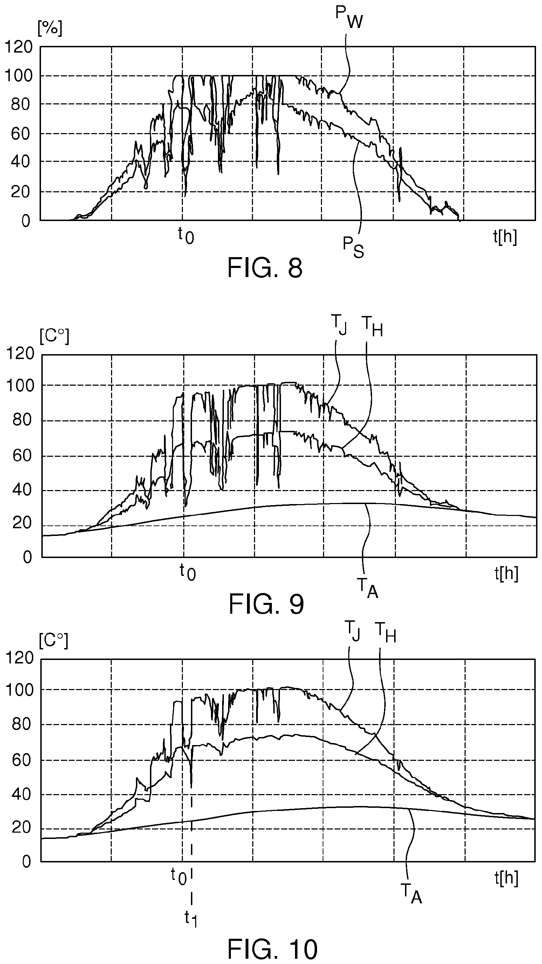

With the use of the device 27 according to the invention, the temperature difference TX of at least a portion of the temperature fluctuations, in particular those caused by weather influences, can be reduced, by which the deterioration of the service life of the inverter circuit 18 is significantly reduced. Compared with Figure 6, it can be seen in Figure 7 that almost no semiconductor chip temperature fluctuations occur in the range between approx. 40 K and 60 K, since the amplitudes of the weather-dependent fluctuations of the device 27 according to the invention or the method according to the invention are reduced and have thus been moved to the left on the abscissa in Figure 7. A large part of these fluctuations thus drops below the limit value of 20 K and is no longer represented. The total of all percentages for the temperature changes of 20 K to approx. 70 K, which indicate the percentage of the service life consumption L of the semiconductor devices due to weather influences, is thus very significantly reduced. This effect is also understandable from the representation of Figures 8-10.

Figure 8 exemplifies the percentage output power of the inverter circuit Pw and the radiation power Ps of the sun standardized to a standard test value (STC) during one day from sunrise to sunset. It can be seen, as expected, that the power increases in the morning with increasing sunlight and decreases in the evening with decreasing sunlight. It also shows that, due to shifting of clouds, considerable power fluctuations occur.

Figure 9 illustrates, for the course of the day shown in Figure 8, the air temperature T_{A}, the component temperature T_{H} and the chip temperature of the semiconductor chip Tⱼ for a system that is not implemented according to the invention. It can be seen that, during the course of the day, due to the ambient conditions, frequent temperature changes in both the component temperature T_{H} and the chip temperature Tⱼ occur at a large temperature gradient. These frequent temperature fluctuations strain the materials of the power semiconductors and reduce their service life.

Figure 10 shows the same temperature curve as Figure 9 for a system with a device 27 according to the invention. It can clearly be seen that, by specifying the temperature drop of the component temperature T_{H} by means of the change default value DV, a large temperature drop is prevented, for example, when the output power of the inverter circuit Pw drops suddenly due to cloudy weather or other ambient conditions, such as at the time of inspection to. At this time of inspection to, without the device 27 according to the invention (Figure 9), a sharp drop in the component temperature T_{H} and the chip temperature Tⱼ is caused. In contrast, due to the slower fall of the component temperature T_{H} according to the change default value DV from the time of inspection to - using the device 27 according to the invention or the method according to the invention (Figure 10) - the temperature difference TX produced between the time of inspection to and a subsequent first time t₁ is significantly reduced compared to conventional systems. Although the chip temperature Tⱼ drops, the drop of the chip temperature Tj is limited by the component temperature T_{H}. The chip temperature Tⱼ cannot drop below the component temperature T_{H}. By comparison of Figure 10 with Figure 9, it can be seen that the number and value of the changes in the component temperature T_{H} and the chip temperature Tⱼ is significantly reduced when the device 27 or the method according to the invention is used. Accordingly, the service life of an inverter circuit 18 and the at least one semiconductor arrangement 19 can be significantly increased.

The invention relates to a device 27 and a method for cooling a semiconductor arrangement 19. The semiconductor arrangement 19 can, for example, be part of an inverter circuit 18 for converting energy from a regenerative energy source 17 into an AC voltage for an AC voltage grid 16. The device 27 comprises a cooling device 28, controllable by means of a control variable S, for cooling the semiconductor arrangement 19. By change-determining means 40, a temperature change value DT of a component temperature T_{H} of the semiconductor arrangement 19 is determined. A control device 30 determines a change difference ΔD between the temperature change value DT and a change default value DV. The change default value DV can be at least temporarily or always less than zero and describes a target temperature change, in particular a target temperature decrease in the component temperature T_{H}, which serves as a reference variable. The change difference ΔD as the control deviation can be transmitted to a regulator 43. The cooling capacity generated via the cooling device 48 is thus limited if the component temperature T_{H} drops due to external influences. The change default value DV can, at least temporarily, be zero or greater than zero.

The control device 30 and the regulator aim to set the change of the component temperature T_{H} according to the change default value DV. If this temperature change is above a certain threshold value, the full cooling capacity is provided via the cooling device 28. If the temperature decrease of the component temperature T_{H} is sufficiently small (sufficient amount greater than zero), the cooling capacity of the cooling device 28 can be reduced and thus a greater decrease in the component temperature T_{H} can be prevented. The mechanical loads are reduced and the service life of the semiconductor arrangement can be increased.

## Claims

1. A device (27) for cooling a semiconductor arrangement (19), wherein the semiconductor arrangement (19) comprises at least one power semiconductor with a semiconductor chip (20), which is arranged on a carrier (21), the device for cooling the semiconductor arrangement comprising:
a cooling device (28), which is configured to generate a control variable (S)-dependent flow of a coolant along the semiconductor arrangement (19);
a change-determining means (40), which is configured to determine a temperature change value (DT), which describes a time-dependent temperature change of a component temperature (TH) of the semiconductor arrangement (19); and
a control device (30) to which the temperature change value (DT) is transmitted, and which is configured to determine a change difference (AD) between the temperature change value (DT) and a change default value (DV) and to determine the control variable (S) depending on the change difference (ΔD), wherein the change default value (DV) specifies a desired or permissible temperature change of the component temperature (TH);
**characterised in that** the change default value (DV) is specified dependent on one or more parameters comprising at least a time of day.

2. A device according to claim 1, wherein the change default value (DV) is at least temporarily or always less than zero.

3. A device according to claim 1 or 2, wherein the parameters comprise a geographical location.

4. A device according to any preceding claim, comprising a component temperature sensor (37) configured to directly measure the component temperature (TH) of the semiconductor arrangement, and configured to transmit the component temperature (TH) measured by the component temperature sensor (37) to the change-determining means (40), wherein the change-determining means (40) are configured to determine the temperature change value (DT) based on the component temperature (TH) and the time.

5. A device according to one of the preceding claims, comprising a coolant temperature sensor (37) configured to measure the coolant temperature (TA) of the coolant for cooling the semiconductor arrangement (19).

6. A device according to one of the preceding claims, comprising a current sensor (36) for measuring a current value (IAC) in the semiconductor arrangement (19) and/or a voltage sensor (35) for measuring a voltage value (VDC) in the semiconductor arrangement (19).

7. A device according to claim 5 or 6, wherein the device is configured to transmit the coolant temperature (TA) measured by the coolant temperature sensor (37) to the change-determining means (40), and to transmit the current value (IAC) and/or the voltage value (VDC) to the change-determining means (40).

8. A device according to claim 7, wherein the change-determining means (40) are configured to determine the temperature change value (DT) by using the coolant temperature (TA), a variable describing the actual cooling capacity of the cooling device (28), the current value (IAC) and/or the voltage value (VDC).

9. A device according to claim 8, wherein the change-determining means (40) comprise a parameter-dependent characteristic (41) of the semiconductor arrangement (19), which describes the relationship between the current value (IAC) and/or the voltage value (VDC), the coolant temperature (TA) and the component temperature (TH) and/or the temperature change value (DT).

10. A device according to one of the preceding claims, wherein the change-determining means (40) are part of the control device (30).

11. A device according to one of the preceding claims, wherein the control device (30) comprises a regulator (43), and wherein the device is configured to transmit the change difference (AD) to the regulator as an input variable, the regulator configured to output a regulator output variable (RA).

12. A device according to one of the preceding claims, wherein the cooling device (28) comprises at least one fan (29) and that the control variable (S) specifies the rotational speed of the fan (29).

13. A device according to one of the preceding claims, comprising an inverter circuit (18), wherein the semiconductor arrangement (19) is part of the inverter circuit (18).

14. A device according to claim 13, **characterized in that** the inverter circuit (18) is configured to be connected to a regenerative energy source (17) and an AC voltage grid (16), and to convert a DC input voltage (VDC) generated by the regenerative energy source (17) into an AC output voltage (VAC) for the AC voltage grid (16).

15. A method for cooling a semiconductor arrangement (19) comprising at least one power semiconductor with a semiconductor chip (20), which is arranged on a carrier (21), the method comprising:
- generating a control variable (S)-dependent flow of a coolant along the semiconductor arrangement (19),
- determining a temperature change value (DT), which describes a time-dependent temperature change of a component temperature (TH) of the semiconductor arrangement (19),
- determining a change difference (AD) between the temperature change value (DT) and a change default value (DV), wherein the change default value (DV) specifies a desired or permissible temperature change of the component temperature,
- determining the control variable (S) depending on the change difference (ΔD);
**characterized by** specifying the change default value (DV) dependent on one or more parameters comprising at least a time of day.

## Patentansprüche

1. Vorrichtung (27) zur Kühlung einer Halbleiteranordnung (19), wobei die Halbleiteranordnung (19) wenigstens einen Leistungshalbleiter mit einem Halbleiterchip (20) aufweist, der auf einem Träger (21) angeordnet ist, wobei die Vorrichtung zur Kühlung der Halbleiteranordnung aufweist:
eine Kühleinrichtung (28), die eingerichtet ist, um eine von einer Regelgröße (S) abhängige Strömung eines Kühlmittels entlang der Halbleiteranordnung (19) zu erzeugen;
eine Änderungsbestimmungseinrichtung (40), die eingerichtet ist, um einen Temperaturänderungswert (DT) zu bestimmen, der eine zeitabhängige Temperaturänderung einer Komponententemperatur (TH) der Halbleiteranordnung (19) beschreibt; und
eine Steuereinrichtung (30), an die der Temperaturänderungswert (DT) übermittelt wird und die eingerichtet ist, um eine Änderungsdifferenz (ΔD) zwischen dem Temperaturänderungswert (DT) und einem Änderungsvorgabewert (DV) zu bestimmen und um in Abhängigkeit von der Änderungsdifferenz (AD) die Regelgröße (S) zu bestimmen, wobei der Änderungsvorgabewert (DV) eine gewünschte oder zulässige Temperaturänderung der Komponententemperatur (TH) festlegt;
**dadurch gekennzeichnet, dass** der Änderungsvorgabewert (DV) in Abhängigkeit von einem oder von mehreren Parametern festgelegt ist, die wenigstens eine Tageszeit umfassen.

2. Vorrichtung nach Anspruch 1, wobei der Änderungsvorgabewert (DV) wenigstens vorübergehend oder stets kleiner als Null ist.

3. Vorrichtung nach Anspruch 1 oder 2, wobei die Parameter eine geografische Lage umfassen.

4. Vorrichtung nach einem beliebigen vorhergehenden Anspruch, die einen Komponententemperatursensor (37) aufweist, der eingerichtet ist, um die Komponententemperatur (TH) der Halbleiteranordnung direkt zu messen, und eingerichtet ist, um die durch den Komponententemperatursensor (37) gemessene Komponententemperatur (TH) an die Änderungsbestimmungseinrichtung (40) zu übermitteln, wobei die Änderungsbestimmungseinrichtung (40) eingerichtet ist, um den Temperaturänderungswert (DT) auf der Basis der Komponententemperatur (TH) und der Zeit zu bestimmen.

5. Vorrichtung nach einem der vorhergehenden Ansprüche, die einen Kühlmitteltemperatursensor (37) aufweist, der eingerichtet ist, um die Kühlmitteltemperatur (TA) des Kühlmittels zur Kühlung der Halbleiteranordnung (19) zu messen.

6. Vorrichtung nach einem der vorhergehenden Ansprüche, die einen Stromsensor (36) zur Messung eines Stromwertes (IAC) in der Halbleiteranordnung (19) und/oder einen Spannungssensor (35) zur Messung eines Spannungswertes (VDC) in der Halbleiteranordnung (19) aufweist.

7. Vorrichtung nach Anspruch 5 oder 6, wobei die Vorrichtung eingerichtet ist, um die durch den Kühlmitteltemperatursensor (37) gemessene Kühlmitteltemperatur (TA) an die Änderungsbestimmungseinrichtung (40) zu übermitteln und um den Stromwert (IAC) und/oder den Spannungswert (VDC) an die Änderungsbestimmungseinrichtung (40) zu übermitteln.

8. Vorrichtung nach Anspruch 7, wobei die Änderungsbestimmungseinrichtung (40) eingerichtet ist, um den Temperaturänderungswert (DT) durch Verwendung der Kühlmitteltemperatur (TA), einer Variablen, die die tatsächliche Kühlleistung der Kühleinrichtung (28) beschreibt, des Stromwertes (IAC) und/oder des Spannungswertes (VDC) zu bestimmen.

9. Vorrichtung nach Anspruch 8, wobei die Änderungsbestimmungseinrichtung (40) eine parameterabhängige Kennlinie (41) der Halbleiteranordnung (19) aufweist, die die Beziehung zwischen dem Stromwert (IAC) und/oder dem Spannungswert (VDC), der Kühlmitteltemperatur (TA) und der Komponententemperatur (TH) und/oder dem Temperaturänderungswert (DT) beschreibt.

10. Vorrichtung nach einem der vorhergehenden Ansprüche, wobei die Änderungsbestimmungseinrichtung (40) Teil der Steuereinrichtung (30) ist.

11. Vorrichtung nach einem der vorhergehenden Ansprüche, wobei die Steuereinrichtung (30) einen Regler (43) aufweist und wobei die Vorrichtung eingerichtet ist, um die Änderungsdifferenz (AD) als eine Eingangsvariable an den Regler zu übermitteln, wobei der Regler eingerichtet ist, um eine Reglerausgangsvariable (RA) auszugeben.

12. Vorrichtung nach einem der vorhergehenden Ansprüche, wobei die Kühleinrichtung (28) wenigstens ein Gebläse (29) aufweist und dass die Regelgröße (S) die Drehzahl des Gebläses (29) festlegt.

13. Vorrichtung nach einem der vorhergehenden Ansprüche, die eine Wechselrichterschaltung (18) aufweist, wobei die Halbleiteranordnung (19) Teil der Wechselrichterschaltung (18) ist.

14. Vorrichtung nach Anspruch 13, **dadurch gekennzeichnet, dass** die Wechselrichterschaltung (18) eingerichtet ist, um mit einer regenerativen Energiequelle (17) und einem Wechselspannungsnetz (16) verbunden zu sein und um eine von der regenerativen Energiequelle (17) erzeugte Eingangsgleichspannung (VDC) in eine Ausgangswechselspannung (VAC) für das Wechselspannungsnetz (16) umzuwandeln.

15. Verfahren zum Kühlen einer Halbleiteranordnung (19), die wenigstens einen Leistungshalbleiter mit einem Halbleiterchip (20) aufweist, der auf einem Träger (21) angeordnet ist, wobei das Verfahren aufweist:
- Erzeugen einer von einer Regelgröße (S) abhängigen Strömung eines Kühlmittels entlang der Halbleiteranordnung (19),
- Bestimmen eines Temperaturänderungswertes (DT), der eine zeitabhängige Temperaturänderung einer Komponententemperatur (TH) der Halbleiteranordnung (19) beschreibt,
- Bestimmen einer Änderungsdifferenz (AD) zwischen dem Temperaturänderungswert (DT) und einem Änderungsvorgabewert (DV), wobei der Änderungsvorgabewert (DV) eine gewünschte oder zulässige Temperaturänderung der Komponententemperatur festlegt,
- Bestimmen der Regelgröße (S) in Abhängigkeit von der Änderungsdifferenz (ΔD);
**gekennzeichnet durch** Festlegen des Änderungsvorgabewertes (DV) in Abhängigkeit von einem oder mehreren Parametern, die wenigstens eine Tageszeit umfassen.

## Revendications

1. Dispositif (27) de refroidissement d'un agencement semi-conducteur (19), dans lequel l'agencement semi-conducteur (19) comprend au moins un semi-conducteur de puissance comportant une puce à semi-conducteur (20), qui est agencé sur un support (21), le dispositif de refroidissement de l'agencement semi-conducteur comprenant :
un dispositif de refroidissement (28), qui est configuré pour générer un écoulement dépendant d'une variable de contrôle (S) d'un agent de refroidissement le long de l'agencement semi-conducteur (19) ;
un moyen de détermination de changement (40), qui est configuré pour déterminer une valeur de changement de température (DT), qui décrit un changement de température dépendant du temps d'une température de composant (TH) de l'agencement semi-conducteur (19) ; et
un dispositif de contrôle(30) auquel la valeur de changement de température (DT) est transmise, et qui est configuré pour déterminer une différence de changement (AD) entre la valeur de changement de température (DT) et une valeur de changement par défaut (DV) et pour déterminer la variable de contrôle (S) en fonction de la différence de changement (ΔD), dans lequel la valeur de changement par défaut (DV) spécifie un changement de température souhaité ou admissible de la température de composant (TH) ;
**caractérisé en ce que** la valeur de changement par défaut (DV) est spécifiée en fonction d'un ou plusieurs paramètres comprenant au moins une heure de la journée.

2. Dispositif selon la revendication 1, dans lequel la valeur de changement par défaut (DV) est au moins temporairement ou toujours inférieure à zéro.

3. Dispositif selon la revendication 1 ou 2, dans lequel les paramètres comprennent un emplacement géographique.

4. Dispositif selon l'une quelconque des revendications précédentes, comprenant un capteur de température de composant (37) configuré pour mesurer directement la température de composant (TH) de l'agencement semi-conducteur, et configuré pour transmettre la température de composant (TH) mesurée par le capteur de température de composant (37) au moyen de détermination de changement (40), dans lequel le moyen de détermination de changement (40) est configuré pour déterminer la valeur de changement de température (DT) sur la base de la température de composant (TH) et du temps.

5. Dispositif selon l'une des revendications précédentes, comprenant un capteur de température d'agent de refroidissement (37) configuré pour mesurer la température d'agent de refroidissement (TA) de l'agent de refroidissement destiné au refroidissement de l'agencement semi-conducteur (19).

6. Dispositif selon l'une des revendications précédentes, comprenant un capteur de courant (36) pour mesurer une valeur de courant (ICA) dans l'agencement semi-conducteur (19) et/ou un capteur de tension (35) pour mesurer une valeur de tension (VCC) dans l'agencement semi-conducteur (19).

7. Dispositif selon la revendication 5 ou 6, dans lequel le dispositif est configuré pour transmettre la température d'agent de refroidissement (TA) mesurée par le capteur de température d'agent de refroidissement (37) au moyen de détermination de changement (40), et pour transmettre la valeur de courant (ICA) et/ou la valeur de tension (VCC) au moyen de détermination de changement (40).

8. Dispositif selon la revendication 7, dans lequel le moyen de détermination de changement (40) est configuré pour déterminer la valeur de changement de température (DT) en utilisant la température d'agent de refroidissement (TA), une variable décrivant la capacité de refroidissement réelle du dispositif de refroidissement (28), la valeur de courant (ICA) et/ou la valeur de tension (VCC).

9. Dispositif selon la revendication 8, dans lequel le moyen de détermination de changement (40) comprend une caractéristique dépendant des paramètres (41) de l'agencement semi-conducteur (19), qui décrit la relation entre la valeur de courant (ICA) et/ou la valeur de tension (VCC), la température d'agent de refroidissement (TA) et la température de composant (TH) et/ou la valeur de changement de température (DT).

10. Dispositif selon l'une des revendications précédentes, dans lequel le moyen de détermination de changement (40) fait partie du dispositif de contrôle(30).

11. Dispositif selon l'une des revendications précédentes, dans lequel le dispositif de contrôle (30) comprend un régulateur (43), et dans lequel le dispositif est configuré pour transmettre la différence de changement (AD) au régulateur en tant que variable d'entrée, le régulateur configuré pour délivrer en sortie une variable de sortie de régulateur (RA).

12. Dispositif selon l'une des revendications précédentes, dans lequel le dispositif de refroidissement (28) comprend au moins un ventilateur (29) et la variable de contrôle (S) spécifie la vitesse de rotation du ventilateur (29).

13. Dispositif selon l'une des revendications précédentes, comprenant un circuit inverseur (18), dans lequel l'agencement semi-conducteur (19) fait partie du circuit inverseur (18).

14. Dispositif selon la revendication 13, **caractérisé en ce que** le circuit inverseur (18) est configuré pour être connecté à une source d'énergie régénérative (17) et à un réseau de tension CA (16), et pour convertir une tension d'entrée CC (VCC) générée par la source d'énergie régénérative (17) en une tension de sortie CA (VCA) pour le réseau de tension CA (16).

15. Procédé de refroidissement d'un agencement semi-conducteur (19) comprenant au moins un semi-conducteur de puissance comportant une puce à semi-conducteur (20), qui est agencé sur un support (21), le procédé comprenant :
- la génération d'un écoulement dépendant d'une variable de contrôle (S) d'un agent de refroidissement le long de l'agencement semi-conducteur (19),
- la détermination d'une valeur de changement de température (DT), qui décrit un changement de température dépendant du temps d'une température de composant (TH) de l'agencement semi-conducteur (19),
- la détermination d'une différence de changement (AD) entre la valeur de changement de température (DT) et une valeur de changement par défaut (DV), dans lequel la valeur de changement par défaut (DV) spécifie un changement de température souhaité ou admissible de la température de composant,
- la détermination de la variable de contrôle (S) en fonction de la différence de changement (AD) ;
**caractérisé par** la spécification de la valeur de changement par défaut (DV) en fonction d'un ou plusieurs paramètres comprenant au moins une heure de la journée.
